Europäisches Patentamt

European Patent Office

Office européen des brevets

(11) Publication number: **0 167 231**
A1

# (12) EUROPEAN PATENT APPLICATION

(21) Application number: 85302865.2

(22) Date of filing: 24.04.85

(51) Int. Cl.⁴: **H 01 L 31/02**

(30) Priority: 02.05.84 US 606013

(43) Date of publication of application:
08.01.86 Bulletin 86/2

(84) Designated Contracting States:
CH DE FR GB IT LI NL

(71) Applicant: ENERGY CONVERSION DEVICES, INC.
1675 West Maple Road
Troy Michigan 48084(US)

(72) Inventor: Nath, Prem.
245 Prospect
Rochester Michigan, 48063(US)

(72) Inventor: Izu, Masatsugu
265 Manor Road
Birmingham Michigan, 48008(US)

(74) Representative: Jackson, Peter Arthur et al,
GILL JENNINGS & EVERY 53-64 Chancery Lane
London WC2A 1HN(GB)

(54) Photoresponsive device incorporating improved back reflector.

(57) A photoresponsive device incorporating a back reflector
(28) disposed between a substrate (11) and a photoactive
semiconductor body (26) and formed of an alloy to promote
adhesion of the substrate and semiconductor body to the
reflector and to prevent diffusion between the reflector and
the semiconductor body. The reflector may be deposited by
sputtering to avoid agglomeration. The reflector may prefer-
ably be an alloy of aluminum or silver containing five to ten
percent silicon. The substrate may be electrically conducting
or may be a thin conductive layer deposited on an electrically
insulating film.

FIG 2

EP 0 167 231 A1

ENERGY CONVERSION DEVICES, INC.         Ref: 50/2646/02

## PHOTORESPONSIVE DEVICE INCORPORATING

## IMPROVED BACK REFLECTOR

Back reflectors in photoresponsive semiconductor devices are commonly formed of highly reflective elements and alloys to provide a suitable light redirecting layer and back contact. These reflectors are deposited on an active semiconductor body forming a photoresponsive device if the semiconductor body is disposed on a light transmissive substrate. Examples of such reflecting contacts are described in U.S. Patent 4,416,052 to Stern for a gallium arsenide device and in Japanese patent applications 56-137179 to Fukatsu and 56-197859 to Ootake for amorphous silicon devices. Different problems are presented, however, in devices in which the incident light does not pass through the substrate. In those devices, the reflective back contact must be interposed between the substrate and the semiconductor. Typically the back reflector is deposited on a substrate and then a semiconductor body is deposited on the reflector. Therefore, in these structures the reflective contact must adhere not only to the semiconductor body, but also to the substrate. In addition, the reflector should prevent or minimize cross diffusion of atoms from the semiconductor and the substrate. However, known reflective materials that have been employed as back reflectors do not solve the adhesion and cross diffusion problems. To alleviate these problems, back reflectors formed on substrates from such highly reflective materials as aluminum, copper and silver, have been sandwiched between layers of chromium, titanium and titanium oxide, and titanium and tin oxide. However, the use of these adhesion promoting and diffusion inhibiting layers (also referred to as "buffer layers") has not been effective. The buffer layers must be very thin to prevent excessive light absorption, decreasing diffusion resistance.

Frequently, a high reflective material cracks or peels from the deposition surface of the substrate. Or, the body of semiconductor material cracks or peels from the deposition surface of a highly reflective back reflector. This cracking and peeling is believed to be due to the cross diffusion of elements at the back reflector-substrate interface and at the back reflector-semiconductor material interface, respectively, causing strain. Even when adhesion-promoting and diffusion-limiting buffer layers are employed to isolate the back reflector from the substrate and the body of semiconductor material, the silver, aluminum or copper material from which those buffer layers are typically fabricated, agglomerate, preventing the adhesion of the subsequently deposited back reflector.

Previous attempts to employ aluminum as a back reflector for an amorphous silicon alloy semiconductor photoresponsive device not receiving light through its substrate have been unsuccessful because of the cross diffusion resulting in formation of an aluminum-silicon compound. Prior attempts at utilizing copper as a back reflector for fluorinated amorphous silicon deposited on a substrate have proven unsatisfactory because of the incompatibility of copper with subsequently deposited fluorinated amorphous silicon alloys. Fluorine reacts with the copper to form a copper-fluorine compound. As with the aluminum-silicon compound, the copper-fluorine compound deleteriously affects the properties of the back reflector and the photoresponsive properties of the semiconductor material.

Attempts to use silver as a back reflector have also been unsuccessful despite the fact that silver back reflective material presents no diffusion problems. Silver and various of its alloys, if deposited in economically thin layers (approximately 50 nanometers thick), tend to agglomerate interfering with the subsequent deposition of uniform layers of semiconductor material. Titanium, tin oxide, and chromium layers were originally proposed and designed for use with silver back reflectors to promote and improve adhesion, but are not capable of effectively preventing the problem of non-uniform surface coverage.

The problems previously encountered are solved in the invention by depositing a highly reflective material having a grain size much smaller than that of previously employed back reflectors. The inventive reflector includes a highly reflective material alloyed with a passivating agent. By appropriately selecting and alloying the highly reflective material, preferably aluminum or silver, with small percentages of the passivating agent, preferably silicon, reducing the grain size, a thin layer of highly reflective material, completely covering the substrate may be deposited.

- 4 -

In one preferred embodiment of the invention, cross diffusion of elements at the substrate-back reflector interface and at the back reflector-semiconductor material interface is substantially reduced by enriching highly reflective aluminum with a relatively small percentage of silicon.  Such enrichment has been found to reduce the amount of cross diffusion substantially and to promote adhesion of the back reflector to the substrate and of the semiconductor material to the back reflector, while simultaneously maintaining the high integrated reflectivity of the alloyed aluminum material.  In its preferred forms, approximately 1-15 percent, and preferably about 5-7 percent, of silicon is alloyed with the highly reflective aluminum.  The deposition can be effected by sputtering from commercially available aluminum-silicon (5 percent silicon) targets.  Other conventional deposition processes such as evaporation, electron beam deposition and d.c. sputtering may be utilized without departing from the spirit or scope of the invention.

For an amorphous silicon alloy photovoltaic device, the optimized range of optical response for an overhead sun shining through the atmosphere, an AM1 condition, is approximately 350-700 nanometers. Therefore, the integrated reflectance must be measured over the entire 350-700 nanometer range rather than at a single wavelength.  The silicon enriched alloy described has an integrated reflectance of approximately 88 percent over the cited range of wavelengths and therefore is suited for photovoltaic applications.

- 5 -

Figure 1 is a fragmentary, cross-sectional view of a tandem photovoltaic device, said device comprising a plurality of p-i-n type cells, each layer of the cells formed from a semiconductor alloy.

Figure 2 is a cross-sectional view illustrating a single cell of the photovoltaic device of Figure 1 incorporating a back reflector or according to the invention that has been deposited on an electrically conductive substrate.

Figure 3 is a cross-sectional view of a single cell of the photovoltaic device of Figure 1 incorporating a back reflector according to the invention that has been deposited on an electrically insulating substrate having a thin conducting coating.

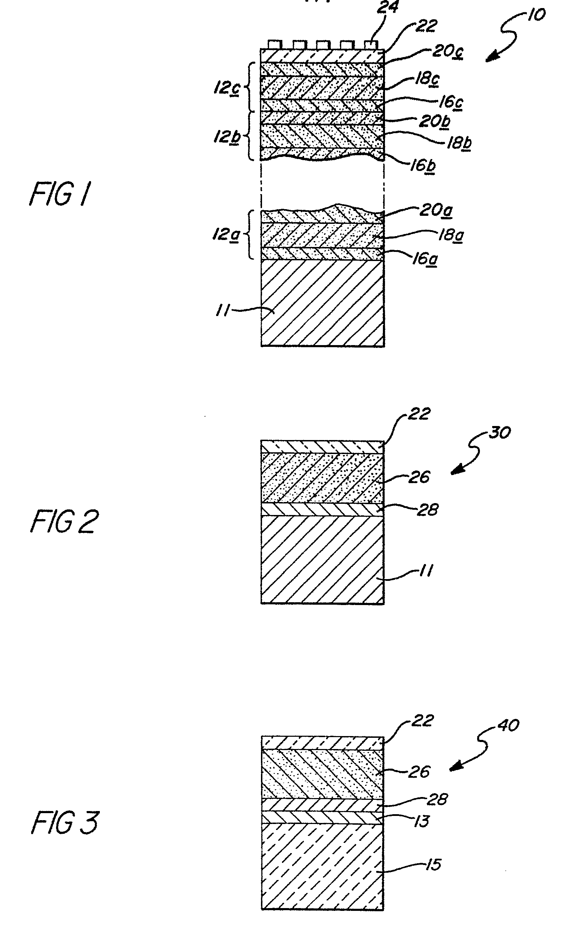

Figure 1 shows a p-i-n type photovoltaic device 10, such as a solar cell, comprising individual p-i-n type cells 12$\underline{a}$, 12$\underline{b}$ and 12$\underline{c}$. A substrate 11 functions as a first bottom electrode, and may be transparent or formed from a metallic material such as stainless steel, mild steel, aluminum, tantalum, molybdenum or chromium, but is not intended to transmit light. Although certain applications may require a thin oxide layer and/or a series of base contacts be disposed on substrate 11 prior to deposition of the semiconductor material, for purposes of this application, the term "substrate" includes not only a flexible film, but also any elements added by preliminary processing.

Each of cells 12$\underline{a}$, 12$\underline{b}$ and 12$\underline{c}$ is fabricated with an amorphous semiconductor body containing a silicon or germanium alloy. Each of the semiconductor bodies includes a n-type conductivity semiconductor layer

- 6 -

20a, 20b and 20c; an intrinsic semiconductor layer 18a, 18b and 18c; and a p-type conductivity semiconductor layer 16a, 16b and 16c. As illustrated, cell 12b is an intermediate cell and, as indicated in Figure 1, additional intermediate cells may be added.

A TCO (transparent conductive oxide) layer 22, formed in the preferred embodiment of indium tin oxide, is deposited on the semiconductor material to form a second electrode and to transmit light to the cells 12. An electrode grid 24 may be applied to layer 22 to shorten the carrier path through the TCO and thus increase current collection efficiency.

While cell 10 illustrated in Figure 1 is a stacked assembly of p-i-n cells, the invention may be employed with other cell arrangements such as single p-i-n cells, stacked or single n-i-p cells, p-n cells, Schottky barrier cells, and the like. Accordingly, in the description and claims that follow, the layer or layers of semiconductor material disposed between substrate 11 and electrode 22 are referred to as the "body of semiconductor material", meaning semiconductor layers for the flow of electrical current including the switching currents of photodiodes and photoresistors and photogenerated currents.

In Figures 2-3, photovoltaic cells 30 and 40, respectively, each include a body of semiconductor material 26 (such as the p-i-n layers of semiconductor material 16, 18 and 20, previously depicted and described with respect to Figure 1). A transparent conductive oxide layer 22, such as indium tin oxide, is deposited on body 26 for transmission of light to the underlying cells. A highly reflective back reflector 28 is disposed between body 26 of semiconductor material and electrode 11. In photovoltaic cell 30, back reflector 26 is deposited directly on an electrically conducting substrate 11 that is preferably formed of nickel, aluminum or stainless steel. In photovoltaic cell 40, back reflector 28 is deposited directly on a thin layer of electrode material 13, such as nickel, silver, indium tin oxide, etc., that is, in turn, deposited on an electrically insulating substrate 15, such as a polyimide. Use of electrically insulating substrate 15 allows electrical interconnection of small-area segments of a large array of photovoltaic cells in series, parallel or combination series-parallel arrangements.

In the preferred embodiment, the highly reflective aluminum-silicon alloy back reflector can be deposited on a substrate by conventional magnetron sputtering. When employed with an elongated web of substrate material, magnetron sputtering permits deposition of the reflective material in a roll-to-roll assembly line process in which the body of semiconductor material is also deposited in the continuous, roll-to-roll process. It is therefore possible to automate production of an amorphous photoresponsive devices entirely.

In the magnetron sputtering example, argon gas is pumped into a deposition chamber. A fixed substrate may be disposed in the chamber or a web of substrate material may continuously pass through the chamber. An aluminum alloy containing five percent silicon sputtering target is disposed in close proximity to the substrate. The impact of argon ions on the target causes ejection of the aluminum-silicon species from the target that are deposited on the substrate. A uniform aluminum-five percent silicon alloy layer of highly reflective material is deposited upon the entire surface area of substrate. In operation, the pressure within the chamber is about 0.3 pascal while the flow rate of the argon gas is maintained at about 40 standard cubic centimeters per minute. Approximately 2.5 kilowatts of power, 540 volts at 6.1 amperes, are employed to eject the aluminum-silicon particles from the target and deliver them to the substrate. A web substrate passes through the deposition chamber at a speed of approximately 40.6 cm. per minute to deposit a thickness of approximately 100 nanometers of aluminum-silicon back reflector material.

The highly reflective aluminum-five percent silicon alloy thus deposited substantially eliminates interdiffusion of elements between the semiconductor material-back reflector and the back reflector-substrate interfaces and promotes adhesion between the materials forming those interfaces.

- 9 -

CLAIMS

1.  A photoresponsive device (30) having a light incident surface for receiving light, said device comprising a substrate (11), a back reflector (28) disposed on said substrate (11) and a body of photoactive semiconductor material (26) disposed on said reflector (28), said light incident surface being disposed opposite said substrate (11), characterized in that said back reflector (28) includes a reflective material alloyed with a second element to promote adhesion of said reflector to said substrate and to said semiconductor body and to inhibit diffusion between said reflector and said semiconductor body.

2.  The device of claim 1 characterized in that said reflective material is selected from the group consisting of aluminum and silver.

3.  The device of one of claims 1 or 2 characterized in that said reflective material is alloyed with silicon.

4.  The device of claim 3 characterized in that said reflector (11) contains approximately one to fifteen percent silicon.

5.  The device of claim 1 characterized in that said reflector consists of an alloy of approximately ninety percent aluminum and approximately five percent silicon.

6.  The device of claim 1 characterized in that said substrate comprises an electrically conducting layer (13) coating by an insulating film (15), said reflector (28) being disposed on said coating (13).

7. A method of forming a photoresponsive device having an improved back reflector characterized in depositing a reflector (28) on a substrate (11), said reflector being formed of a reflective material alloyed with a second element, and depositing a photoactive semiconductor body (26) on said reflector (28) for receiving light opposite the interface of said semiconductor body (26) and said reflector (28), said reflector alloy promoting adhesion of said reflector (28) to said substrate (11) and said semiconductor body (26) and inhibiting diffusion between said reflector (28) and said semiconductor body (11).

8. The method of claim 7 characterized in that aluminum or silver is deposited as said reflective material.

9. The method of one of claims 7 or 8 characterized in that silicon is deposited as said second element.

10. The method of claim 9 characterized in that said reflector (11) contains approximately one to fifteen percent silicon.

11. The method of any one of claims 7, 8, 9 or 10 characterized in that said reflector is deposited by sputtering a target.

12. The method of claim 7 characterized in that said reflector is deposited by sputtering a target composed of approximately ninety five percent aluminum and approximately five percent silicon.

13. The method of claim 7 characterized in depositing an electrically conducting coating (13) on an insulating film (15) to form said substrate, said reflector (28) being deposited on said coating (13).

FIG 1

1/1

FIG 2

FIG 3

European Patent
Office

**EUROPEAN SEARCH REPORT**

**0167231**

Application number

EP  85 30 2865

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | GB-A-2 116 775  (ENERGY CONVERSION DEVICES) * Page 3, lines 44-86; page 3, line 125 - page 4, line 10 * | 1,2,7, 8,13 | H 01 L   31/02 |
| | --- | | |
| A,D | US-A-4 416 052  (T.G. STERN) * Column 3, lines 25-34 * | 2,8,11 | |
| | --- | | |
| A | US-A-3 609 470  (L.L. KULPER) * Claim 1 * | 3,4,9, 10 | |
| | ----- | | |

**TECHNICAL FIELDS SEARCHED (Int. Cl.4)**

H 01 L   31/00

The present search report has been drawn up for all claims

| Place of search | Date of completion of the search | Examiner |
|---|---|---|
| BERLIN | 02-07-1985 | GIBBS C.S. |